# EUROPÄISCHE PATENTSCHRIFT

(11) **EP 1 814 225 B1**
(45) Veröffentlichungstag und Bekanntmachung des Hinweises auf die Patenterteilung: **02.09.2009**
(21) Anmeldenummer: 06023442.4
(22) Anmeldetag: 10.11.2006
(51) Int. Cl.: H03K 17/06

(54) **Schaltungsanordnung mit einem Schalttransistor, einer Ansteuerschaltung sowie einer Versorgungsschaltung**
Circuit arrangement comprising a switching transistor, a driving circuit and a supply circuit
Agencement de circuit comprenant un transistor à commutation, un circuit de commande et un circuit d'alimentation

(30) Priorität: 24.01.2006 DE 102006003157
(43) Veröffentlichungstag der Anmeldung: 01.08.2007
(73) Patentinhaber: Insta Elektro GmbH, 58511 Lüdenscheid (DE)
(72) Erfinder: Mundinger, Harald, Dipl.-Ing., 58849 Herscheid (DE); Grosch, Volker, Dipl.-Ing., 45549 Sprockhövel (DE); Großen, Thomas, Dipl.-Ing., 58239 Schwerte (DE)

(56) Entgegenhaltungen:
- DE-A1- 2 808 156
- DE-A1- 4 209 396
- DE-A1- 10 336 237
- US-A1- 5 942 812
- US-A1- 6 049 447
- US-B2- 6 876 245

## Beschreibung

Die vorliegende Erfindung geht von einer gemäß Oberbegriff des Hauptanspruches konzipierten Schaltungsanordnung mit zumindest einem elektronischen Schalter aus.

Derartige Schaltungsanordnungen mit zumindest einem elektronischen Schalter sind in der Regel dafür vorgesehen, den Strom von elektrischen Verbrauchern, wie z. B. Leuchten, Wärmeerzeugern, Motoren usw. bedarfsgerecht ein- und auszuschalten. Außerdem werden solche Schaltungsanordnungen mit zumindest einem elektronischen Schalter zur Schutzbeschaltung von elektrischen Generatoren, wie z. B. Solarmodulen, Brennstoffzellen usw. benutzt.

Durch die US-A1-5 942 812 ist eine dem Oberbegriff des Hauptanspruches entsprechende Schaltungsanordnung bekannt geworden. Der elektronische Schalter ist als Transistor realisiert und somit statisch leistungslos ansteuerbar. Ferner wird der Transistor über eine zugeordnete Ansteuerschaltung mit geringem Leistungsverbrauch angesteuert, wobei die zur Ansteuerung des Transistors und zur Versorgung der Ansteuerschaltung notwendigen Leistung mittels einer Versorgungsschaltung aus der geringen Spannung gewonnen wird, die im durchgeschalteten Zustand des zugehörigen Transistors über dem Transistor abfällt. Die Versorgungsschaltung erzeugt dabei eine zur Ansteuerung des Transistors und zur Versorgung der Ansteuerschaltung hinreichend hohe Spannung.

Durch die Druckschrift "Elektronik-Handbuch Modular" der Firma Albrecht Jung GmbH & Co. KG, 4. Auflage aus dem Jahr 2003, Seite 66 ist zudem ein elektronischer Leistungssteller bekannt geworden. Bei dieser Schaltungsanordnung wird die Versorgung durch den Restphasenwinkel des elektronischen Schalters realisiert. Eine solche Versorgung führt dazu, dass die angeschlossenen elektrischen Verbraucher nicht ihre volle Leistung entfalten können, weil der elektronische Schalter durch das gepulste Ein- und Ausschalten gegenüber dem Verbraucher einen scheinbaren Widerstand darstellt.

Des weiteren sind durch die nicht vorveröffentlichten Druckschriften DE 10 2005 012 213 und DE 10 2005 018 463 Schaltungsanordnungen bekannt geworden, die jeweils als Schutzbeschaltung von Solarmodulen ausgeführt sind. Bei diesen Schaltungsanordnungen ist ein zeitweiliges Öffnen des elektronischen Schalters zur Selbstversorgung notwendig. Durch das zeitweilige Öffnen des elektronischen Schalters kommt es jedoch zwangsläufig zu einem nicht idealen Verhalten des Schalters, was sich zum einen in einem erhöhten scheinbaren Widerstand des elektronischen Schalters zeigt und was zum anderen zu Störungen auf den Zuleitungen führt, wodurch leitungsgebundene und nicht leitungsgebundene Kommunikation behindert wird.

Außerdem ist durch die US-B2-6 876 245 eine Schaltungsanordnung bekannt geworden, die zur Schaltung von Wechselspannung zwei antiseriell geschaltete elektronische Schalter aufweist.

Zudem ist durch die DE-A1-28 08 156 eine Schaltungsanordnung bekannt geworden, bei der zwei magnetisch gekoppelte Wicklungen im Zusammenhang mit einem Bipolartransistor in Einsatz kommen.

Der vorliegenden Erfindung liegt deshalb die Aufgabe zugrunde, eine Schaltungsanordnung mit zumindest einem elektronischen Schalter anzugeben, bei der der elektronische Schalter ohne zusätzliche Energiequellen oder Energiespeicher und ohne Erzeugung störender Schaltspiele seine Selbstversorgung sicherstellt und bei der gleichzeitig sehr geringe Restspannungen und damit geringe Durchlassverluste und somit auch eine geringe Wärmeentwicklung auftritt.

Erfindungsgemäß wird diese Aufgabe durch die im unabhängigen Anspruch angegebenen Merkmale gelöst.

Weist die Versorgungsschaltung zwei magnetisch gekoppelte Wichlungen auf, ist es besonders vorteilhaft, dass sich die Restspannung über das Windungszahlverhältnis einstellen lässt und der thermischen Drift des MOSFET entgegenwirkt. Durch eine zusätzliche dritte Wicklung wird eine weitgehende Skalierung der Ausgangsspannung der Versorgungsschaltung möglich.

Weitere vorteilhafte Ausgestaltungen des erfindungsgemäßen Gegenstandes sind in den abhängigen Ansprüchen angegeben. Anhand von Ausführungsbeispielen sei die Erfindung im Prinzip näher erläutert, dabei zeigt:
- Fig. 1:: ein Prinzipschaltbild einer Schaltungsanordnung mit einem elektronischen Schalter für Gleichstrom;
- Fig. 2:: ein Prinzipschaltbild einer Schaltungsanordnung mit einem elektronischen Schalter als Schutzbeschaltung für Solarmodule;
- Fig. 3:: ein Prinzipschaltbild einer Schaltungsanordnung mit einem elektronischen Schalter für Wechselstrom;
- Fig. 4:: ein Prinzipschaltbild einer Schaltungsanordnung mit einem elektronischen Schalter für Wechselstrom mit zwei Ansteuerschaltungen, zwei Versorgungsschaltungen und zwei antiseriell geschalteten Transistoren;
- Fig. 5:: ein Prinzipschaltbild einer Schaltungsanordnung mit einem elektronischen Schalter zur Verwendung als Solar-Bypass (ohne Verpolschutz);
- Fig. 6:: ein Prinzipschaltbild einer Schaltungsanordnung mit einem elektronischen Schalter zur Verwendung als Solar-Bypass (mit aktiv arbeitendem Verpolschutz);
- Fig. 7:: ein Prinzipschaltbild einer erfindungsgemäßen Schaltungsanordnung mit einem elektronischen Schalter zur Verwendung als Solar-Bypass (mit passiv arbeitendem Verpolschutz);
- Fig. 8:: ein Prinzipschaltbild einer erfindungsgemäßen Schaltungsanordnung mit einem elektronischen Schalter zur Verwendung als Solar-Bypass (mit passiv arbeitendem und aktiv arbeitendem Verpolschutz);
- Fig. 9:: ein Prinzipschaltbild einer Schaltungsanordnung mit einem elektronischen Schalter für Gleichstrom, insbesondere für Dimmer.

Wie aus den Figuren hervorgeht, besteht eine solche Schaltungsanordnung mit zumindest einem elektronischen Schalter hauptsächlich aus einem Transistor M, einer Ansteuerschaltung A und einer Versorgungsschaltung V.

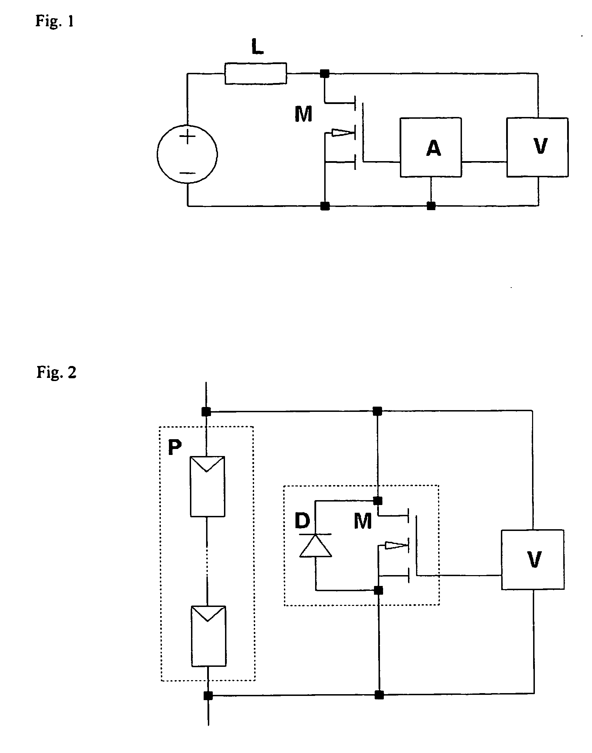

Wie insbesondere aus Figur 1 hervorgeht, versorgt die Versorgungsschaltung V die Ansteuerschaltung A und darüber die Steuerelektrode des Transistors M mit der zum Betrieb notwendigen elektrischen Leistung. Die Versorgungsschaltung V stellt dabei die notwendige elektrische Leistung sowohl dann zur Verfügung, wenn der Transistor M ausgeschaltet ist, als auch dann zur Verfügung, wenn der Transistor M eingeschaltet ist. Die Versorgungsschaltung V tut dies, weil das Übersetzungsverhältnis (beispielsweise 420 : 8) sehr hoch ist, so dass auch bei niedrigen Durchlassspannungen über dem Transistor M die zur Versorgung notwendige Leistung mit einer ausreichend hohen Spannung zur Verfügung gestellt wird. Als Verbraucher L sind an solch eine Schaltungsanordnung z. B. Lampen, Heizelemente, Motoren usw. anschließbar.

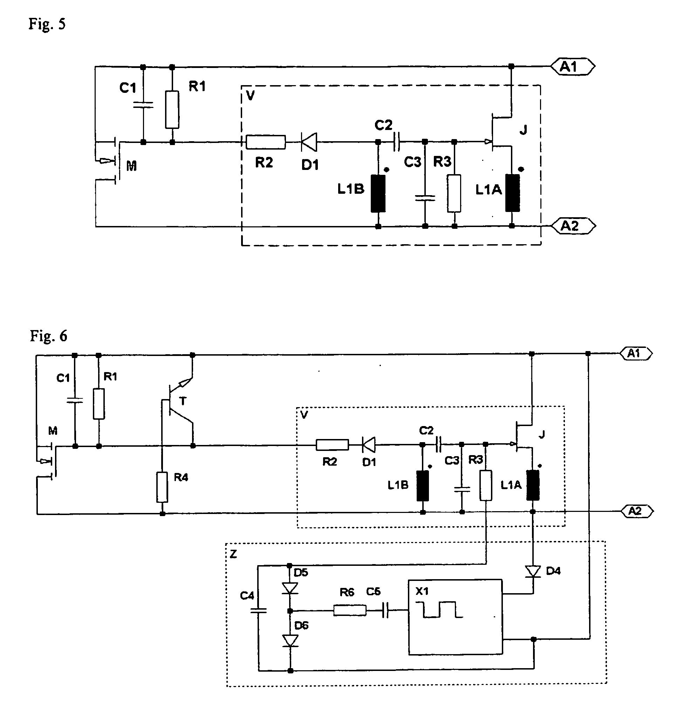

Wie insbesondere aus Figur 2 hervorgeht, dient diese Schaltungsanordnung mit einem elektronischen Schalter als Solar-Bypass für Solarmodule P. Die Diode D wird im Bypassfall durch den Transistor M gebrückt, wodurch der Spannungsabfall der Gesamtanordnung deutlich unter derjenigen Spannung liegt, die ohne den Transistor M über der Diode D abfallen würde. Durch diese Gegebenheiten wird die Verlustleistung und somit die thermische Belastung für die als Solar-Bypass-Diode wirkende Schaltung nach Fig. 5 erheblich reduziert. Die Versorgungsschaltung V liefert für die Steuerelektrode des Transistors M nur dann eine Spannung, wenn die Diode D in Durchlassrichtung betrieben wird, so dass sich die Anordnung aus Diode D, Transistor M und Versorgungsschaltung V im Normalbetrieb des Solarmoduls so verhält, wie eine gewöhnliche Solar-Bypass-Diode.

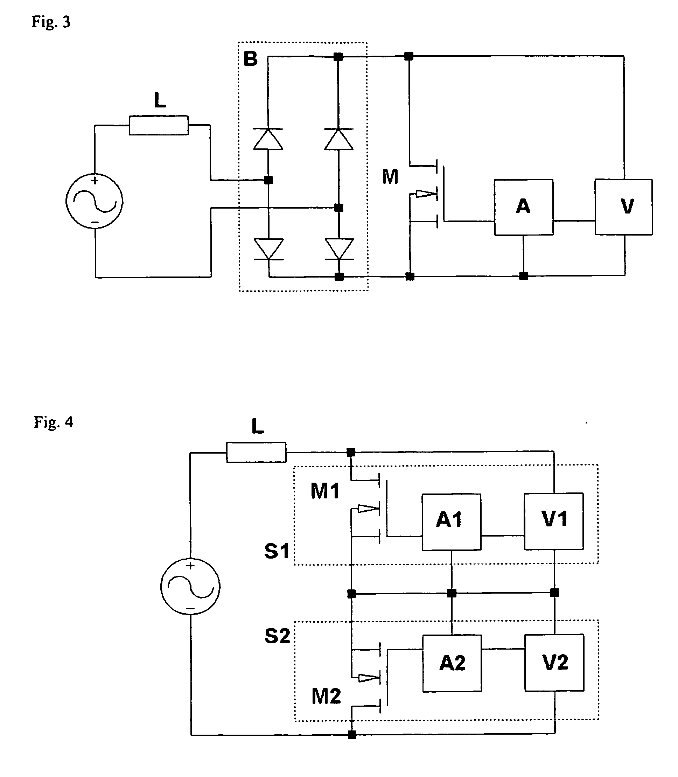

Wie insbesondere aus Figur 3 und Figur 4 hervorgeht, kann bei Wechselstromschaltern die Ansteuerschaltung A und darüber der Transistor M über die Versorgungsschaltung V auch dann mit der notwendigen Leistung versorgt werden, wenn der elektronische Schalter der Schaltungsanordnung geschlossen ist. Dies geschieht zum einen ohne ein zeitweises Öffnen des elektronischen Schalters und zum anderen ohne den Einsatz zusätzlicher Energiequellen. Wie insbesondere aus Figur 3 hervorgeht, ist der Verbraucher L über eine Gleichrichterbrücke B an die Schaltungsanordnung angebunden. Das hat den Vorteil, dass nur ein Transistor M, eine Ansteuerschaltung A und nur eine Versorgungsschaltung V benötigt wird. Wie insbesondere aus Figur 4 hervorgeht, ist der elektronische Schalter durch zwei antiseriell geschaltete Transistoren M1, M2 und entsprechend zwei Ansteuerschaltungen A1, A2 sowie zwei Versorgungsschaltungen V1, V2 realisiert. Eine solche Anordnung hat den Vorteil, dass eine deutlich geringere Restspannung über den elektronischen Wechselschalter abfällt, als bei einer Anordnung nach Fig. 3. Den Versorgungsschaltungen V nach Fig. 3 und Fig. 4 ist weiterhin gemeinsam, dass diese zur Überbrückung der Nulldurchgänge der Wechselspannung einen Kondensator enthält.

Wie insbesondere aus Figur 5 hervorgeht, wird die Schaltungsanordnung mit einem elektronischen Schalter als Solar-Bypass für Solarmodule P verwendet. Grundsätzliches ist zu einer solchen Verwendung bereits der Figur 2 und den entsprechenden Passagen der Beschreibung zu entnehmen. Im Detail wird zu dieser Schaltungsanordnung nachfolgend näher eingegangen.

Zum Verständnis dieser Schaltungsanordnung gemäß Fig. 5 sei vorab darauf hingewiesen, dass der Transistor M als MOSFET ausgebildet ist und hier im sogenannten Inversbetrieb betrieben wird, bei dem ausgenutzt wird, dass die Drain-Source-Strecke bei auf unipolarer Leitung beruhenden Transistoren in beide Richtungen leitfähig ist. Da im interessanten Betriebsfall die parasitäre Diode des als MOSFET ausgebildeten Transistors M leitet, liegen Drain und Source des Transistors M auf annähernd gleichem Potential, so dass eine hinreichend hohe und positive Gate-Drain-Spannung auch eine positive Gate-Source-Spannung und damit ein Leiten des Transistors M nach sich zieht.

Beim Anlegen einer Spannung an die Anschlüsse A1 und A2 in Fig. 5 dargestellten als Bypass-Diode ausgeführten Schaltungsanordnung leitet zunächst die parasitäre Diode des Transistors M, wobei die Flussspannung in Abhängigkeit vom Transistor-Typ, Vorwärtsstrom und der Temperatur des Transistors M im Bereich von 0,5 Volt bis ca. 1 Volt variiert. Diese Flussspannung liegt zunächst auch an der Versorgungsschaltung V an, die aus dem selbstleitenden N-Kanal Sperrschicht-Feldeffekt-Transistor J, dem Übertrager mit den beiden magnetisch gekoppelten Wicklungen L1A, L1B, den Kondensatoren C2, C3, den Widerständen R2, R3 sowie der Diode D1 besteht. Die Funktionsweise der Versorgungsschaltung V wird im Folgenden kurz beschrieben.

Durch ein großes Windungszahlenverhältnis der Wicklungen L1A, L1B des Übertragers (im Beispiel 420 : 8) werden kleinste Änderungen des Stromes durch die Wicklung L1A, die z. B. durch thermisches Rauschen des JFET J oder sonstige Störungen hervorgerufen werden, verstärkt und an das Rückkoppelnetzwerk L1B, C2, C3 und R3 weitergeleitet. Durch den gewählten Wicklungssinn des Übertragers kommt eine Mitkopplung zustande, so dass sich bei Erfüllung der Schwingungs-Bedingung nach Barkhausen eine stabile Oszillation einstellt, deren Frequenz sich im Wesentlichen aus der Induktivität der Wicklung L1B, den Kapazitäten der Kondensatoren C2, C3 sowie den hier im Allgemeinen nicht zu vernachlässigenden Sperrschichtkapazitäten des JFET J und der Diode D1 ergibt. Die Amplitude der Schwingung ist innerhalb eines Arbeitsbereiches näherungsweise proportional zur Betriebsspannung des Oszillators, die sich ihrerseits aus der Spannung über der der als Bypass-Diode ausgeführten Schaltungsanordnung ergibt. Der Widerstand R3 sorgt zusammen mit dem Kondensator C2 dafür, dass sich an der Steuerelektrode des JFET J ein Gleichspannungs-Offset derart einstellt, dass der Spitzenwert der Oszillation der Spannung an der Steuerelektrode des JFET J in etwa der Durchlassspannung der Gate-Source-Strecke des JFET J entspricht. Die Kapazität des Kondensators C3 erhöht die wirksame Eingangskapazität des JFET J und hat eine Kapazität, die das Mehrfache der Eingangskapazität des JFET J beträgt. Hierdurch wird der Einfluss von Variationen der Eingangskapazität, die beispielsweise durch Exemplarstreuungen hervorgerufen werden, reduziert und damit das Verhalten des Oszillators stabilisiert.

Entscheidend für die vorliegende Anwendung ist die Eigenschaft des JFET J, selbstleitend zu sein und bereits bei einer Gate-Source-Spannung von 0 Volt arbeiten zu können. Somit arbeitet die Schaltungsanordnung bei oben genannter Barkhausen-Bedingung bereits bei sehr kleiner Versorgungsspannung, die deutlich unter derjenigen liegt, die mit konventionellen, auf bipolaren Silizium-Halbleitern oder bipolaren Germanium-Halbleitern beruhenden Schaltungen erreicht werden kann.

Sobald sich eine Schwingungsamplitude einstellt, die über der Wicklung L1B Spannungsverläufe mit Spitzenwerten oberhalb der Spannung des Kondensators C1 erzeugt, wird im Spannungsmaximum über der Diode D1 und über dem Widerstand R2 Energie in den Kondensator C1 und damit in die Steuerelektrode (Gate) des Transistors M übertragen. Der Widerstand R2 begrenzt den Spitzenstrom, während der Kondensator C1 parallel zur Gate-Source-Kapazität des Transistors M liegt und damit die resultierende Kapazität vergrößert. Der Widerstand R1 sorgt im ausgeschalteten Zustand für einen definierten Aus-Zustand des als MOSFET ausgebildeten Transistors M.

Mit zunehmender Gate-Source-Spannung wird der Kanal des Transistors M niederohmiger. Im Gegenzug sinkt bei eingeprägtem Strom die Drain-Source-Spannung über dem Transistor M und damit auch die Betriebsspannung des Oszillators. Nach kurzer Zeit stellt sich somit ein stationärer Betriebszustand ein, in dem der Strom durch die Schaltungsanordnung überwiegend durch den Transistor M geführt wird und damit bei geeigneter Wahl des Transistors M über der Schaltungsanordnung eine Spannung abfällt, die erheblich unter der Flussspannung der parasitären Diode liegt und damit an der Schaltungsanordnung eine erheblich reduzierte Verlustleistung entsteht.

Weitere vorteilhafte Eigenschaften einer solchermaßen ausgeführten Schaltungsanordnung sind:
a. Es erhöht sich mit der Drain-Source-Spannung automatisch die Betriebsspannung des Oszillators, was zu einer erhöhten Spannung an der Steuerelektrode des Transistors M und damit zu einer Reduktion des Durchlasswiderstandes des Transistors M führt. Das Wegdriften der Temperatur des als MOSFET ausgebildeten Transistors M wird also durch eine inhärente Gegenkopplung verringert. Bei Schaltungsanordnungen gemäß des Standes der Technik hingegen geschieht die Ansteuerung des Transistors M im Allgemeinen durch eine konstante Spannung. Erwärmt sich der Transistor aufgrund der entstehenden Verlustleistung, so steigt dessen Durchlasswiderstand und damit bei konstantem Strom auch der Spannungsabfall über dem Transistor. Hierdurch steigt wiederum die Verlustleistung, was einer thermischen Mitkopplung gleichkommt und ohne besondere Kühlmaßnahmen zu einer thermischen Überlastung und letztendlich Zerstörung des Transistors führen kann.
b. Bei der vorliegenden Schaltungsanordnung stellt sich im stationären Zustand die Steuerspannung des Transistors M genau so ein, dass über der Schaltungsanordnung bei dem eingeprägtem Strom ein Spannungsabfall entsteht, mit dem der Oszillator genau diese Steuerspannung erzeugt. Der Spannungsabfall über dem Transistor M ist somit in Grenzen unabhängig von seinem typspezifischen, minimalen Durchlasswiderstand. Es kann somit ein als MOSFET ausgebildeter Transistor M gewählt werden, der bei gefordertem Maximalstrom ungefähr den erlaubten Spannungsabfall erzeugt. Man kann somit im Allgemeinen einen kleineren und preiswerteren, als MOSFET ausgebildeten Transistor M einsetzen.

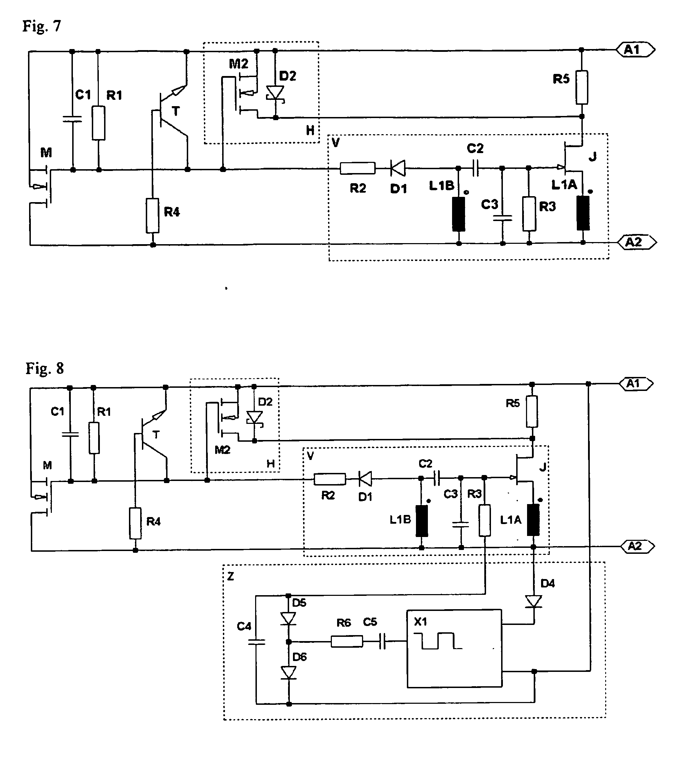

Die Schaltungsanordnungen gemäß Figur 6 und Figur 7 sind gegenüber einer Schaltungsanordnung gemäß Figur 5 um Elemente ergänzt, welche eine solche Schaltungsanordnung befähigen, Sperrspannungen aufzunehmen, die beispielsweise dann auftreten, wenn in der Anwendung als Solar-Bypass-Diode das Solarmodul P im Normalbetrieb arbeitet und damit die Bypass-Diode in Sperrrichtung betrieben wird.

Ohne besondere Maßnahmen würde im Sperrbetrieb bei genügend hoher Sperrspannungsbelastung zum einen der JFET J den typspezifischen, maximalen Drain-Strom führen, der je nach anliegender Spannung zur thermischen Überlastung des JFET J führen würde, zum anderen würde der Transistor M über den Widerstand R2, die Diode D1 und die Wicklung L1B durchgesteuert und damit die Schaltungsanordnung leitend.

Den Schaltungsanordnungen gemäß Figur 6 und Figur 7 ist eine Anordnung eines weiteren Transistors T gemein, der im Sperrbetrieb über den Widerstand R4 durchgesteuert wird, damit die Steuerelektrode des Transistors M gegen die Source-Elektrode klemmt und somit den Transistor M definiert im Aus-Zustand hält.

Die Schaltungsanordnung gemäß Figur 6 beseitigt die mögliche Überlastung des JFET J dadurch, dass eine negative Spannung an die Steuerelektrode des JFET J geführt wird, die unterhalb der Abschnürspannung des JFET J liegt und damit den JFET J definiert ausschaltet. Diese negative Spannung muss immer dann erzeugt werden, wenn die Polarität über der Schaltungsanordnung derart ist, dass die Bypass-Diode sperren würde und wenn die anliegende Spannung so hoch wird, dass das Produkt aus Strom durch den JFET J und Spannung über der Schaltungsanordnung den JFET J thermisch zerstören könnte. Die negative Spannung muss daher erst bei Spannungen im Bereich einiger Volt erzeugt werden, was eine solche schaltungstechnische Ausführung erheblich vereinfacht.

Die negative Spannung kann daher einerseits über einen einfachen Rechteckoszillator X1 mit nachgeschalteter Ladungspumpe erzeugt werden, wobei der Oszillator aus diskreten Transistoren aufgebaut werden kann. Andererseits kann aber auch ein einfacher Timerbaustein oder ein in die Schaltungsanordnung integrierter Mikrocontroller die Rechteckspannung erzeugen, mit deren Hilfe eine Ladungspumpe oder ein Inverswandler die negative Hilfsspannung erzeugt. Wie weiter oben bereits beschrieben, stellt die Versorgung des Oszillators in der Regel kein Problem dar, da im Sperrbetrieb der Schaltungsanordnung eine ausreichend hohe Spannung zur Verfügung steht. Sollte diese Spannung nicht zur Verfügung stehen, so ist auch die über dem JFET J anstehende Spannung gering und damit die Gefahr einer thermischen Zerstörung des JFET J nicht gegeben. Der Strombedarf der Schaltungsanordnung sollte jedoch möglichst gering gehalten werden, da sich dieser Strombedarf im "Aus-Zustand" als scheinbarer Leckstrom des elektronischen Schalters bemerkbar macht. Aufgrund der sehr geringen Belastung der negativen Hilfsspannung, die im Wesentlichen durch die Leckströme der Kondensatoren C2, C3, C4 und der Steuerelektrode des JFET J zustande kommt, ist dies technisch kein Problem.

Die Schaltungsanordnung gemäß Figur 7, die im Vergleich zu einer Schaltungsanordnung gemäß Figur 6 vereinfacht ist, verhindert erfindungsgemäß die Überlastung des JFET J durch den in Reihe zum JFET J geschalteten ohmschen Widerstand R5. Dieser ohmsche Widerstand R5 muss zum einen hochohmig genug sein, um im Sperrbetrieb der Schaltungsanordnung den JFET J vor thermischer Überlastung zu schützen. Zum anderen muss der ohmsche Widerstand R5 aber niederohmig genug sein, um dem Oszillator das Anschwingen und Aufrechterhalten einer stabilen Schwingung auch bei niedriger Versorgungsspannung zu ermöglichen. Beide Eigenschaften können durch die zusätzliche Anordnung einer Anlaufhilfe H erreicht werden, die aus einem selbstsperrenden Kleinsignal-Feldeffekttransistor M2 und einer weiteren Schottky-Diode D2 besteht. Die Schottky-Diode D2 überbrückt den ohmschen Widerstand R5, sobald die Spannung über der Schaltungsanordnung die Flussspannung der Schottky-Diode D2 erreicht. Der Oszillator schwingt an und erzeugt an der Steuerelektrode des Transistors M und des weiteren Transistors M2 eine ansteigende Spannung. Der Transistor M und der weitere Transistor M2 sind hierbei so gewählt, dass die Schwellspannung des weiteren Transistors M2 etwas unterhalb derjenigen des Transistors M liegt. Hierdurch ist gewährleistet, dass der weitere Transistor M2 leitet, bevor der Transistor M die Spannung über der Schaltungsanordnung auf niedrigere Werte zurückzieht. Da nun aber der weiter Transistor M2 leitet, wird der ohmsche Widerstand R5 sehr niederohmig überbrückt, so dass der Oszillator ähnliche Betriebsbedingungen vorfindet, wie als wenn der ohmsche Widerstand R5 nicht vorhanden wäre. In der Praxis kann der ohmsche Widerstand R5 sehr hochohmig gewählt werden, oder aber sogar ganz entfallen, was dann zu einer in der Praxis im Wesentlichen nur durch die Sperrspannungen der Diode D2 sowie der Transistor M und der weitere Transistor M2 sowie der Belastbarkeit der Widerstände R2 und R4 begrenzten Sperrspannungsfestigkeit der Schaltungsanordnung führt.

Die Schaltungsanordnung gemäß Figur 8 schließlich kombiniert die Ansätze gemäß einer Schaltungsanordnung gemäß Figur 6 und Figur 7, wobei insbesondere der ohmsche Widerstand R5 dann den Strom begrenzt, wenn der Rechteckoszillator X1 noch keine hinreichend hohe negative Spannung zum Sperren des JFET J erzeugen kann oder der Kondensator C4 noch zu laden ist.

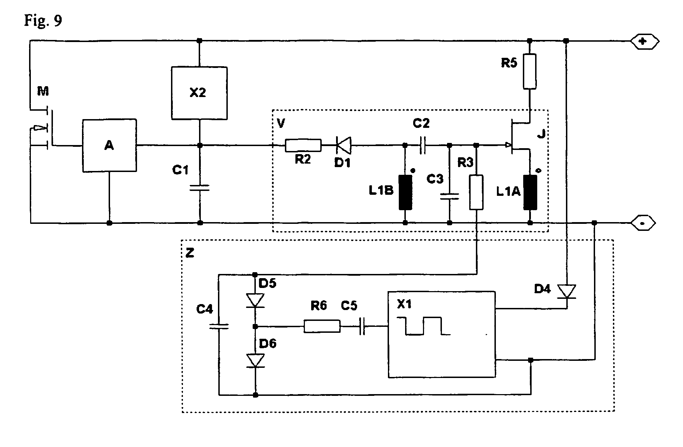

Die in Figur 9 dargestellte Schaltungsanordnung ist für eine Anwendung als elektronischer Gleichstromschalter ausgeführt und insbesondere zur Verwendung bei Dimmern vorgesehen. Basierend auf dieser für Gleichstromdimmer vorgesehenen Grundschaltung lassen sich durch Modifikationen auch Wechselstromschalter für Wechselstromdimmer ableiten, wobei Bauelemente mit geeigneten Sperrspannungsfestigkeiten eingesetzt werden müssen.

Bei der in Figur 9 dargestellten Schaltungsanordnung dient der Transistor M dazu, einen Verbraucher gesteuert über die Ansteuerschaltung A bedarfsgerecht zu schalten. Ist der Verbraucher ausgeschaltet, so kann die sehr stromsparend aufgebaute Ansteuerschaltung A leicht über einen Spannungsregler X2 versorgt werden und verursacht dadurch nur einen sehr kleinen Stromfluss durch den Verbraucher, der sich als sehr kleiner und damit tolerierbarer "Leckstrom" bemerkbar macht.

Wird nun der als MOSFET ausgebildete Transistor M durchgesteuert, um den Verbraucher einzuschalten, so steht an dem Spannungsregler X2 keine hinreichend hohe Spannung mehr zur Verfügung, um die Ansteuerschaltung A zu versorgen.

Um auch hier ohne Pulsen des Laststroms (Verbraucher) auszukommen, bzw. um zusätzliche Energiespeicher oder eine zusätzliche Zuleitung zu vermeiden, wird analog zu der in Figur 1 dargestellten Schaltungsanordnung mit Hilfe der oben beschriebenen und in Figur 1 gezeigten Versorgungsschaltung V aus der geringen Restspannung über dem Transistor M eine hinreichend hohe Spannung zur Versorgung der Ansteuerschaltung A erzeugt, die es letztendlich erlaubt, den Ein-Zustand des Transistors M beliebig lange aufrecht zu erhalten.

Wäre die Restspannung über dem Transistor M zu gering, um die zum Betrieb der Ansteuerschaltung A und vor allem die zum Durchsteuern des Transistors M notwendige Spannung durch die Versorgungsschaltung V zu erzeugen, was z. B. durch einen zu geringen Strom durch den Verbraucher oder einen sehr niedrigen Durchlasswiderstand des Transistors M zustande kommen könnte, reduziert sich die Steuerspannung am Transistor M, wodurch der Transistor M hochohmiger wird. Die Restspannung über dem Transistor M stabilisiert sich folglich automatisch auf einen Wert, der für das Arbeiten der Versorgungsschaltung V und damit der Ansteuerschaltung A erforderlich ist.

Ebenso wie die in Figur 6 gezeugte Schaltungsanordnung sorgt auch die in Figur 9 gezeigte Schaltungsanordnung mit einem eigenen Schaltungsteil Z dafür, dass im Aus-Zustand des Transistors M die Versorgungsschaltung V vor Überlastung geschützt wird, was letztendlich auf das gezielte Ausschalten des JFET J innerhalb der Versorgungsschaltung V hinausläuft.

Zu beachten ist, dass bei dieser Umsetzung einer Schaltungsanordnung die Betriebspolarität der Versorgungsschaltung V und des eigenen Schaltungsteils Z gleich sind, während bei einer Schaltung gemäß Figur 6 die Polaritäten unterschiedlich sind.

Der eigene Schaltungsteil Z wird bei einer solchen Schaltungsanordnung erst dann aktiv, wenn die Spannung der Versorgungsschaltung V Werte angenommen hat, die es erlauben, die Ansteuerschaltung A über den Spannungsregler X2 mit der notwendigen Spannung zu versorgen.

Die Ansteuerschaltung A kann je nach Anwendung der Schaltungsanordnung mit einem Pulsweitenmodulator, einer Echtzeituhr, einem Temperatursensor, einem Helligkeitssensor usw. versehen werden.

## Patentansprüche

1. Schaltungsanordnung mit zumindest einem elektronischen Schalter, wobei als elektronischer Schalter eine Anordnung aus parallel, seriell und/oder antiseriell geschalteten Transistoren (M) benutzt wird, die statisch quasi leistungslos angesteuert werden, und dass diese Transistoren (M) über eine oder mehrere zugeordnete Ansteuerungsschaltungen (A) mit geringem Leistungsverbrauch angesteuert werden, und dass die zur Ansteuerung der Transistoren (M) und zur Versorgung der Ansteuerschaltung (A) notwendige Leistung mittels einer Versorgungsschaltung (V) aus der geringen Spannung gewonnen wird, die im durchgeschalteten Zustand des zugehörigen Transistors (M) über dem Transistor (M) abfällt, und dass die durch diese Versorgungsschaltung (V) erzeugte Spannung eine zur Ansteuerung der Transistoren (M) und zur Versorgung der Ansteuerschaltung (V) hinreichend hohe Spannung erzeugt, **dadurch gekennzeichnet, dass** die Versorgungsschaltung (V) durch einen zusätzlich in Reihe eingeführten ohmschen Widerstand (R5) und einer zu diesem parallel geschalteten Anlaufhilfe (H), die aus einem Feldeffekttransistor (M2) und einer Schottky-Diode (D2) besteht, gegen Überlastung geschützt wird, wobei der ohmsche Widerstand (R5) den Strom begrenzt und die parallelgeschaltete Anlaufhilfe (H) den ohmschen Widerstand (R5) überbrückt, sobald die Versorgungsschaltung (V) mit richtiger Polarität und geringer Spannung betrieben wird.

2. Schaltungsanordnung nach Anspruch 1, **dadurch gekennzeichnet, dass** die Versorgungsschaltung (V) aus einem Oszillator mit einem JFET (J) als aktivem Element sowie mindestens zwei magnetisch gekoppelten Wicklungen (L1A, L1B) eines Übertragers und mindestens einem Kondensator (C2) besteht, die zusammen bei sehr niedrigen Spannungen eine stabile Dauerschwingung ermöglicht.

3. Schaltungsanordnung nach Anspruch 2, **dadurch gekennzeichnet, dass** die Versorgungsschaltung (V) zur Erzeugung der Spannung durch eine weitere Zusatzschaltung (Z) vor Verpolung geschützt wird, die bei Verpolung eine negative Hilfsspannung erzeugt, mit deren Hilfe der JFET (J) gesperrt wird.

4. Schaltungsanordnung nach einem der Ansprüche 1 bis 3, **dadurch gekennzeichnet, dass** zumindest ein Transistor (M) als MOSFET ausgeführt ist.

5. Schaltungsanordnung nach einem der Ansprüche 1 bis 4, **dadurch gekennzeichnet, dass** die Ansteuerschaltung (A) eine Echtzeituhr enthält.

6. Schaltungsanordnung nach einem der Ansprüche 1 bis 5, **dadurch gekennzeichnet, dass** zumindest ein Transistor (M) eine parasitäre, antiparallele Diode enthält oder zumindest einem Transistor (M) eine Diode antiparallel geschaltet ist.

7. Schaltungsanordnung nach einem der Ansprüche 1 bis 6, **dadurch gekennzeichnet, dass** die Einheit aus Transistor (M), antiparalleler Diode und Versorgungsschaltung (V) als Bypass-Diode zum Schutz zumindest eines Solarmoduls dient, und dass der Transistor (M) durch die Versorgungsschaltung (V) direkt angesteuert wird.

8. Schaltungsanordnung nach einem der Ansprüche 1 bis 7, **dadurch gekennzeichnet, dass** die Schaltungsanordnung zur Schaltung von Wechselspannung zwei antiseriell geschaltete, elektronische Schalter (S1, S2) aufweist.

9. Schaltungsanordnung nach einem der Ansprüche 1 bis 8, **dadurch gekennzeichnet, dass** der Schaltungsanordnung zur Schaltung von Wechselspannung ein Brückengleichrichter (B) vorgeschaltet ist.

10. Schaltungsanordnung nach einem der Ansprüche 1 bis 9, **dadurch gekennzeichnet, dass** die Schaltungsanordnung als Gleichstromdimmer ausgeführt ist.

11. Schaltungsanordnung nach einem der Ansprüche 1 bis 9, **dadurch gekennzeichnet, dass** die Schaltungsanordnung als Wechselstromdimmer ausgeführt ist.

12. Schaltungsanordnung nach einem der Ansprüche 1 bis 11, **dadurch gekennzeichnet, dass** die Schaltungsanordnung zumindest einen Mikrocontroller aufweist.

## Claims

1. Circuit arrangement with at least one electronic switch, with an arrangement of transistors (M) connected in parallel, serial and/or anti-serial being used as electronic switches which are actuated statically and quasi without any control current, and that these transistors (M) are actuated by way of one or more dedicated control circuits (A) with a low power consumption, and that the power needed for actuating the transistors (M) and energising the control circuit (A) is gained by means of a supply circuit (V) from the low voltage that is released via the transistor (M) in the conductive state of the relevant transistor (M), and that the voltage generated by this supply circuit (V) generates a voltage which is sufficiently high to actuate the transistors (M) and to supply the control circuit (A), **characterised by the fact that** the supply circuit (V) is protected against overloading by an additional ohmic resistance (R5) inserted in series and by a start-up auxiliary (H) which is connected parallel to this and comprises a field-effect transistor (M2) and a Schottky diode (D2), with the ohmic resistance (R5) limiting the current and with the parallel-connected start-up auxiliary (H) by-passing the ohmic resistance (R5) once the supply circuit (V) is operated with the correct polarity and a low voltage.

2. Circuit arrangement in accordance with Claim 1, **characterised by the fact that** the supply circuit (V) consists of an oscillator with a JFET (J) as active element and at least two magnetically coupled windings (L1A, L1B) of a transformer and at least one capacitor (C2), which together facilitate a stable sustained oscillation at very low voltages.

3. Circuit arrangement in accordance with Claim 2, **characterised by the fact that** the supply circuit (V) for generating the voltage is protected against polarity reversal by a further additional circuit (Z) which, in the event of polarity reversal, generates a negative auxiliary voltage with the aid of which the JFET (J) is blocked.

4. Circuit arrangement in accordance with any of Claims 1 to 3, **characterised by the fact that** at least one transistor (M) is designed as a MOSFET.

5. Circuit arrangement in accordance with any of Claims 1 to 4, **characterised by the fact that** the control circuit (A) incorporates a real-time clock.

6. Circuit arrangement in accordance with any of Claims 1 to 5, **characterised by the fact that** at least one transistor (M) incorporates a parasitic, anti-parallel diode, or a diode is connected in anti-parallel to at least one transistor (M).

7. Circuit arrangement in accordance with any of Claims 1 to 6, **characterised by the fact that** the unit made up of transistor (M), anti-parallel diode and supply circuit (V) serves as a by-pass diode for protecting at least one solar module, and that the transistor (M) is actuated directly by the supply circuit (V).

8. Circuit arrangement in accordance with any of Claims 1 to 7, **characterised by the fact that** the circuit arrangement features two anti-serial connected electronic switches (S1, S2) for the purpose of connecting the alternating voltage.

9. Circuit arrangement in accordance with any of Claims 1 to 8, **characterised by the fact that** a bridge-connected rectifier (B) is connected upstream of the circuit arrangement for the purpose of connecting the alternating voltage.

10. Circuit arrangement in accordance with any of Claims 1 to 9, **characterised by the fact that** the circuit arrangement is designed as a direct current dimmer.

11. Circuit arrangement in accordance with any of Claims 1 to 9, **characterised by the fact that** the circuit arrangement is designed as an alternating current dimmer.

12. Circuit arrangement in accordance with any of Claims 1 to 11, **characterised by the fact that** the circuit arrangement features at least one microcontroller.

## Revendications

1. Montage électrique avec au moins un interrupteur, pour lequel on utilise comme interrupteur électrique un montage de transistors (M) montés en parallèle, série et/ou antisérie qui sont commandés statiquement quasiment sans câble, et que ces transistors (M) sont commandés via un ou plusieurs montages électriques (A) affectés à faible consommation de puissance, et que la puissance nécessaire à la commande des transistors (M) et à l'alimentation du circuit de commande (A) est obtenue par un circuit d'alimentation (V) à partir de la faible tension qui retombe à l'état interconnecté du transistor (M) affecté via le transistor (M) et que la tension générée par ce circuit d'alimentation (V) génère une tensions suffisamment haute pour commander les transistors (M) et pour alimenter le circuit de commande (V), **caractérisé en ce que** le circuit d'alimentation (V) est protégé contre la surcharge par une résistante (R5) ohmique introduite en série en supplément et une assistance au démarrage (H) montée parallèlement à celui-ci consistant en un transistor à effet de champ (M2) et une diode de Schottky (D2), pour lequel la résistance ohmique (R5) limite le courant et l'assistance au démarrage (H) montée en parallèle ponte la résistance ohmique (R5) dès que le circuit d'alimentation (V) est exploité avec la polarité correcte et une faible tension.

2. Montage électrique selon revendication 1, **caractérisé en ce que** le circuit d'alimentation (V) consiste en un oscillateur avec un JFET (J) comme élément actif ainsi qu'au moins deux bobines à accouplement magnétique (L1A, L1B) d'un transmetteur et au moins un condensateur (C2) qui permet ensemble une oscillation constante stable à des tensions très faibles.

3. Montage électrique selon revendication 2, **caractérisé en ce que** le circuit d'alimentation (V) pour la génération de la tension est protégé par un autre circuit supplémentaire (Z) pour la polarisation qui génère lors de la polarisation une tension auxiliaire négative qui permet de bloquer le JFET (J).

4. Montage électrique selon l'une des revendications 1 à 3, **caractérisé en ce qu'**au moins un transistor (M) est exécuté comme MOSFE.

5. Montage électrique selon l'une des revendications 1 à 4, **caractérisé en ce que** le circuit de commande (A) contient une horloge à temps réel.

6. Montage électrique selon l'une des revendications 1 à 5, **caractérisé en ce qu'**au moins un transistor (M) contient une diode parasitaire, antiparallèle ou au moins une diode est montée en parallèle à un transistor.

7. Montage électrique selon l'une des revendications 1 à 6, **caractérisé en ce que** l'unité composée du transistor (M), de la diode antiparallèle et du circuit d'alimentation (V) sert de diode de bypass pour la protection d'au moins un module solaire et que le transistor (M) est directement commandé par le circuit d'alimentation (V).

8. Montage électrique selon l'une des revendications 1 à 7, **caractérisé en ce que** le montage électrique pour la commutation de tension alternative présente deux interrupteurs électroniques (S1, S2) à montage antiparallèle.

9. Montage électrique selon l'une des revendications 1 à 8, **caractérisé en ce qu'**un redresseur à pont (B) est monté avant le montage électrique pour la commutation de tension alternative.

10. Montage électrique selon l'une des revendications 1 à 9, **caractérisé en ce que** le montage électrique est exécuté comme un variateur de courant continu.

11. Montage électrique selon l'une des revendications 1 à 9, **caractérisé en ce que** le montage électrique est exécuté comme un variateur de courant alternatif.

12. Montage électrique selon l'une des revendications 1 à 9, **caractérisé en ce que** le montage électrique présente au moins un microcontrôleur.
